Europäisches Patentamt

European Patent Office

Office européen des brevets

(11) Veröffentlichungsnummer: **0 298 329 B1**

(12) **EUROPÄISCHE PATENTSCHRIFT**

(45) Veröffentlichungstag der Patentschrift: **09.03.94**

(21) Anmeldenummer: **88110172.9**

(22) Anmeldetag: **25.06.88**

(51) Int. Cl.⁵: **H03K 17/945**, G05F 1/56

(54) Elektronisches, vorzugsweise berührungslos arbeitendes Schaltgerät.

(30) Priorität: **07.07.87 DE 3722336**

(43) Veröffentlichungstag der Anmeldung:
**11.01.89 Patentblatt 89/02**

(45) Bekanntmachung des Hinweises auf die
Patenterteilung:
**09.03.94 Patentblatt 94/10**

(84) Benannte Vertragsstaaten:
**CH DE FR GB LI SE**

(56) Entgegenhaltungen:
EP-A- 0 169 468
DE-A- 3 447 002
DE-B- 2 548 288
FR-A- 2 233 760
US-A- 4 563 632

**U.Tietze, Ch. Schenk : Halbleiterschaltungstechnik Springer Verlag 1983, Seiten 62-64**

**Patent Abstract of Japan Band 6, nr.9 (E-
90)(887) 20 Januar 1982 & JP-A-56131229**

**Patent Abstract of Japan Band 9,
nr.173(E-329)(1896)18 Juli 1985 & JP-A-
6046124**

(73) Patentinhaber: **i f m electronic gmbh
Teichstrasse 4
D-45127 Essen(DE)**

(72) Erfinder: **Lamarche, Jean-Luc, Dipl.-Ing.
Zeppelinstrasse 1
D-7994 Langenargen(DE)**

(74) Vertreter: **Gesthuysen, Hans Dieter, Dipl.-Ing.
et al
Patentanwälte Gesthuysen + von Rohr
Postfach 10 13 33
D-45013 Essen (DE)**

## Beschreibung

Die Erfindung betrifft ein elektronisches, vorzugsweise berührungslos arbeitendes Schaltgerät, mit einem von außen beeinflußbaren Anwesenheitsindikator, z. B. einem Oszillator, mit einem dem Anwesenheitsindikator nachgeordneten Schaltverstärker, mit einem von dem Anwesenheitsindikator über den Schaltverstärker steuerbaren elektronischen Schalter, z. B. einem Transistor, einem Thyristor oder einem Triac, mit einer Speiseschaltung zur Darstellung der Speisespannung für den Anwesenheitsindikator und für den Schaltverstärker und mit einem Konstantstromgenerator, z. B. für die Stromversorgung einer Leuchtdiode, wobei der Konstantstromgenerator einen Strommeßwiderstand, einen Stromspiegel und einen Stromsteuertransistor aufweist und der Strommeßwiderstand und die Kollektor-Emitter-Strecke des Stromsteuertransistors in Reihe liegen.

Elektronische Schaltgeräte der hier grundsätzlich in Rede stehenden Art sind kontaktlos ausgeführt und werden seit nunmehr etwa zwanzig Jahren in zunehmendem Maße anstelle von elektrischen, mechanisch betätigten Schaltgeräten, die kontaktbehaftet ausgeführt sind, verwendet, insbesondere in elektrischen bzw. elektronischen Meß-, Steuer- und Regelkreisen. Das gilt insbesondere für sogenannte Annäherungsschalter, d. h. für elektronische Schaltgeräte, die berührungslos arbeiten. Mit solchen Annäherungsschaltern wird indiziert, ob sich ein Beeinflussungselement, für das der entsprechende Annäherungsschalter sensitiv ist, dem Annäherungsschalter hinreichend weit genähert hat. Hat sich nämlich ein Beeinflussungselement, für das der entsprechende Annäherungsschalter sensitiv ist, dem Annäherungsschalter hinreichend weit genähert, so steuert der einen wesentlichen Bestandteil des Annäherungsschalters bildende Anwesenheitsindikator den elektronischen Schalter um; bei einem als Schließer ausgeführten Schaltgerät wird der nicht leitende elektronische Schalter nunmehr leitend, während bei einem als Öffner ausgeführten Schaltgerät der leitende elektronische Schalter nunmehr sperrt. (Mit Schaltgeräten der in Rede stehenden Art kann auch indiziert werden, ob eine physikalische Größe eines Beeinflussungsmediums, für die das Schaltgerät sensitiv ist, einen entsprechenden Wert erreicht hat.)

Wesentlicher Bestandteil von elektronischen Schaltgeräten der zuvor beschriebenen Art ist also u. a. der von außen beeinflußbare Anwesenheitsindikator.

Als Anwesenheitsindikator kann z. B. ein induktiv oder kapazitiv beeinflußbarer Oszillator vorgesehen sein; es handelt sich dann um induktive oder kapazitive Annäherungsschalter. Als Anwesenheitsindikator kann auch ein Fotowiderstand, eine Fotodiode oder ein Fototransistor vorgesehen sein; es handelt sich dann um optoelektronische Annäherungsschalter (vgl. z. B. die deutschen Offenlegungsschriften 28 24 582, 30 38 102, 33 27 328, 35 14 643, 35 18 025 und 36 05 885).

Bei induktiven Annäherungsschaltern gilt für den Oszillator, solange ein Metallteil einen vorgegebenen Abstand noch nicht erreicht hat, $K \times V = 1$ mit $K$ = Rückkopplungsfaktor und $V$ = Verstärkungsfaktor des Oszillators, d. h. der Oszillator schwingt. Erreicht das entsprechende Metallteil den vorgeschriebenen Abstand, so führt die zunehmende Bedämpfung des Oszillators zu einer Verringerung des Verstärkungsfaktors $V$, so daß $K \times V < 1$ wird, d. h. der Oszillator hört auf zu schwingen. Bei kapazitiven Annäherungsschaltern gilt für den Oszillator, solange ein Ansprechkörper die Kapazität zwischen einer Ansprechelektrode und einer Gegenelektrode noch nicht hinreichend vergrößert hat, also einen vorgegebenen Abstand noch nicht erreicht hat, $K \times V < 1$, d. h. der Oszillator schwingt nicht. Erreicht der Ansprechkörper den vorgegebenen Abstand, so führt die steigende Kapazität zwischen der Ansprechelektrode und der Gegenelektrode zu einer Vergrößerung des Rückkopplungsfaktors $K$, so daß $K \times V = 1$ wird, d. h. der Oszillator beginnt zu schwingen. Bei beiden Ausführungsformen - induktiver Annäherungsschalter und kapazitiver Annäherungsschalter - wird abhängig von den unterschiedlichen Zuständen des Oszillators der elektronische Schalter, z. B. ein Transistor, ein Thyristor oder ein Triac, gesteuert.

Optoelektronische Annäherungsschalter weisen einen Lichtsender und einen Lichtempfänger auf und werden auch als Lichtschranken bezeichnet. Dabei unterscheidet man zwischen einem Lichtschrankentyp, bei dem der Lichtsender und der Lichtempfänger auf entgegengesetzten Seiten einer Überwachungsstrecke angeordnet sind, und einem Lichtschrankentyp, bei dem der Lichtsender und der Lichtempfänger am gleichen Ende einer Überwachungsstrecke angeordnet sind, während ein am anderen Ende der Überwachungsstrecke angeordneter Reflektor den vom Lichtsender ausgehenden Lichtstrahl zum Lichtempfänger zurückreflektiert. In beiden Fällen spricht der Anwesenheitsindikator an, wenn der normalerweise vom Lichtsender zum Lichtempfänger gelangende Lichtstrahl durch ein in die Überwachungsstrecke gelangtes Beeinflussungselement unterbrochen wird. Es gibt jedoch auch Lichtschranken des zuletzt beschriebenen Lichtschrankentyps, bei dem der vom Lichtsender kommende Lichtstrahl nur durch ein entsprechendes Beeinflussungselement zum Lichtempfänger zurückreflektiert wird.

Elektronische, berührungslos arbeitende Schaltgeräte sind anfangs mit einer Reihe von Problemen behaftet gewesen, - gemessen an elektrischen, mechanisch betätigten Schaltgeräten -, nämlich u. a. mit dem Problemen "Darstellung einer Speisespannung für den Anwesenheitsindikator und den Schaltverstärker", "Ausbildung des Anwesenheitsindikators", "Kurzschlußfestigkeit" und "Einschaltimpulsverhinderung".

Bei elektronischen Schaltgeräten, die über einen Außenleiter mit einem Pol einer Betriebsspannungsquelle und nur über einen weiteren Außenleiter mit einem Anschluß eines Verbrauchers verbindbar sind, ist die Darstellung einer Speisespannung bzw. eines Speisestroms für den Anwesenheitsindikator und für den Schaltverstärker nicht problemlos, weil ja sowohl im leitenden Zustand als auch im gesperrten Zustand des Schaltgerätes die Speisespannung bzw. der Speisestrom dargestellt werden muß.

Es ist belanglos, ob man von Darstellung einer Speisespannung oder von Darstellung eines Speisestroms spricht. Darstellung steht hier für Ableitung aus dem am Schaltgerät auftretenden Spannungsabfall bzw. aus dem über das Schaltgerät geführten Betriebsstrom (leitender Zustand) bzw. aus der am Schaltgerät anstehenden Betriebsspannung bzw. aus dem über das Schaltgerät fließenden Reststrom (gesperrter Zustand). Es ist deshalb belanglos, ob man von Darstellung einer Speisespannung oder von Darstellung eines Speisestroms spricht, weil der Anwesenheitsindikator und der Schaltverstärker selbstverständlich eine Speisespannung und einen Speisestrom benötigen.

Von ihrer Funktion als Schaltgeräte her soll bei den in Rede stehenden Schaltgeräten im leitenden Zustand praktisch kein Spannungsabfall auftreten und im gesperrten Zustand praktisch kein Reststrom fließen. Da aber dann, wenn bei Schaltgeräten mit nur zwei Außenleitern im leitenden Zustand kein Spannungsabfall aufträte, auch keine Speisespannung für den Anwesenheitsindikator und den Schaltverstärker gewonnen werden könnte, und dann, wenn im gesperrten Zustand kein Reststrom flösse, auch kein Speisestrom gewonnen werden könnte, gilt für alle elektronischen Schaltgeräte mit nur zwei Außenleitern, daß im leitenden Zustand ein Spannungsabfall auftritt und im gesperrten Zustand ein Reststrom fließt.

Aus dem, was zuvor ausgeführt worden ist, folgt, daß dann, wenn schon, ungewollt, aber funktionsnotwendig bei elektronichen Schaltgeräten mit nur zwei Außenleitern im leitenden Zustand ein Spannungsabfall auftritt und im gesperrten Zustand ein Reststrom fließt, der Spannungsabfall und der Reststrom so gering wie möglich sein sollen.

Einleitend ist gesagt, daß zu dem elektronischen Schaltgerät, von dem die Erfindung ausgeht, u. a. ein dem Anwesenheitsindikator nachgeordneter Schaltverstärker und ein elektronischer Schalter gehören und daß der elektronische Schalter von dem Anwesenheitsindikator über den Schaltverstärker steuerbar ist. Schaltverstärker ist hier ganz allgemein zu verstehen und umfaßt die gesamte Schaltung zwischen dem Signalausgang des Anwesenheitsindikators und dem Steuereingang des elektronischen Schalters, also den gesamten Signalübertragungsweg zwischen dem Anwesenheitsindikator und dem elektronischen Schalter. Selbstverständlich kann der so verstandene Schaltverstärker bzw. der Signalübertragungsweg aus mehreren Funktionseinheiten bestehen.

Einleitend ist auch bereits darauf hingewiesen, daß zu dem elektronischen Schaltgerät, von dem die Erfindung ausgeht, ein Konstantstromgenerator gehört, - z. B. für die Stromversorgung einer Leuchtdiode, die eine optisch wahrnehmbare Aussage über den Schaltzustand eines solchen Schaltgerätes macht.

Da nun einerseits elektronische Schaltgeräte der in Rede stehenden Art, insbesondere solche mit nur zwei Außenleitern, im leitenden Zustand einen geringen Spannungsabfall aufweisen sollen, z. B. von nur 2,5 V, andererseits an einer Leuchtdiode ein Spannungsabfall von ca. 2 V auftritt, darf der Konstantstromgenerator nur eine besonders geringe Restspannung benötigen; Restspannung meint dabei die Differenz zwischen der zur Verfügung stehenden Speisespannung und dem Spannungsabfall an dem Verbraucher, den der Konstantstromgenerator speist, also beispielsweise dem Spannungsabfall an einer Leuchtdiode.

Aus US-A-4 563 632 ist ein Konstantstromgenerator mit einem Strommeßwiderstand, einem zwei Transistoren enthaltenden Stromspiegel und einem Stromsteuertransistor bekannt, bei dem der Meßwiderstand und die Kollektor-Emitter-Strecke des Stromsteuertransistors in Reihe liegen, der Emitter eines der Stromspiegeltransistoren an die Verbindung des Emitters des Stromsteuertransistors mit dem Strommeßwiderstand und der Emitter des anderen Stromspiegeltransistors an das andere Ende des Strommeßwiderstandes angeschlossen ist.

Der Erfindung liegt die Aufgabe zugrunde, das bekannte elektronische Schaltgerät, von dem die Erfindung ausgeht, so auszugestalten und weiterzubilden, daß aus den dargelegten Gründen der Konstantstromgenerator eine besonders geringe Restspannung aufweist, - bzw. einen Konstantstromgenerator mit einer besonders geringen Restspannung anzugeben.

Das erfindungsgemäße elektronische Schaltgerät, bei dem die zuvor hergeleitete und dargelegte Aufgabe gelöst ist, ist nun dadurch gekennzeichnet, daß der Stromspiegel zwei sekundäre Stromspiegeltransistoren aufweist, daß ein zweiter Stromspiegel mit einem primären Stromspiegeltransistor und einem sekundären Stromspiegeltransistor vorgesehen ist, daß die Emitter-Kollektor-Strecke des ersten sekundären Stromspiegeltransistors des ersten Stromspiegels mit der Kollektor-Emitter-Strecke des primären Stromspiegeltransistors des zweiten Stromspiegels und die Emitter-Kollektor-Strecke des zweiten sekundären Stromspiegeltransistors des ersten Stromspiegels mit der Kollektor-Emitter-Strecke des sekundären Stromspiegeltransistors des zweiten Stromspiegels in Reihe liegen, daß der Emitter des primären Stromspiegeltransistors des zweiten Stromspiegels an die Verbindung des Emitters des Stromsteuertransistors mit dem Strommeßwiderstand und der Emitter des sekundären Stromspiegeltransistors des zweiten Stromspiegels an das andere Ende des Strommeßwiderstandes angeschlossen sind und daß die Basis des Stromsteuertransistors an die Verbindung des zweiten sekundären Stromspiegeltransistors des ersten Stromspiegels mit dem sekundären Stromspiegeltransistor des zweiten Stromspiegels angeschlossen ist.

Die Lehre der Erfindung geht davon aus, daß für die Basis-Emitter-Spannung $U_{BE}$ eines Transistors gilt:

$$U_{BE} = V_T \times l_n \times \frac{I}{I_S},$$

wobei $V_T$ eine physikalische Konstante (~25,7 mV), I der Strom und $I_S$ der Sättigungsstrom, $l_n$ eine nur von der Geometrie des Transistors abhängige Konstante sind.

Geht man davon aus, daß der Stromsteuertransistor eine sehr große Stromverstärkung hat und bezeichnet man mit

$n_1$ den Stromspiegelfaktor des ersten Stromspiegels, zwischen dem primären Stromsteuertransistor und den ersten sekundären Stromsteuertransistor,

$n_2$ den Stromspiegelfaktor des ersten Stromspiegels, zwischen dem primären Stromspiegeltransistor und dem zweiten sekundären Stromspiegeltransistor,

$n_3$ den Stromspiegelfaktor des zweiten Stromspiegels,

$I_1$ den Strom durch die Emitter-Kollektor-Strecke des primären Stromspiegeltransistors des ersten Stromspiegels,

$I_2$ den Strom durch die Emitter-Kollektor-Strecke des ersten sekundären Stromspiegeltransistors des ersten Stromspiegels und durch die Kollektor-Emitter-Strecke des primären Stromspiegeltransistors des zweiten Stromspiegels,

$I_3$ den Strom durch die Emitter-Kollektor-Strecke des zweiten sekundären Stromspiegeltransistors des ersten Stromspiegels und durch die Kollektor-Emitter-Strecke des sekundären Stromspiegeltransistors des zweiten Stromspiegels,

$U_{BE,2}$ die Basis-Emitter-Spannung des primären Stromspiegeltransistors des zweiten Stromspiegels,

$U_{BE,3}$ die Basis-Emitter-Spannung des sekundären Stromspiegeltransistors des zweiten Stromspiegels,

$U_{BE,2/3}$ die Differenz zwischen der Basis-Emitter-Spannung des primären Stromspiegeltransistors des zweiten Stromspiegels einerseits, der Basis-Emitter-Spannung des sekundären Stromspiegeltransistors des zweiten Stromspiegels andererseits,

so gilt folgendes:

$$I_2 = n_1 \times I_1$$

$$I_3 = n_2 \times I_1$$

$$U_{BE,2} = V_T \times l_n \times \frac{I_2 / n_3}{I_S}$$

$$U_{BE,3} = V_T \times l_n \times \frac{I_3}{I_S}$$

$$U_{BE,2/3} = V_T \times l_n \times \frac{n_3 \times n_2}{n_1}$$

Also ist bei dem Konstantstromgenerator des erfindungsgemäßen elektronischen Schaltgerätes die Restspannung nur abhängig einerseits von der Konstanten $V_T$ und andererseits dem Logarithmus des Produktes aus dem Stromspiegelfaktor des zweiten Stromspiegels und dem Stromspiegelfaktor des ersten Stromspiegels, zwischen dem primären Stromspiegeltransistor und dem zweiten sekundären Stromspiegeltransistor, dividiert durch den Stromspiegelfaktor des ersten Stromspiegels, zwischen dem primären Stromspiegeltransistor und dem ersten sekundären Stromspiegeltransistor.

Die Lehre der Erfindung hat auch für sich Bedeutung, also losgelöst von ihrer Anwendung bei einem elektronischen, vorzugsweise berührungslos arbeitenden Schaltgerät. Deshalb ist Gegenstand der Erfindung auch ein Konstantstromgenerator mit einem Strommeßwiderstand, einem Stromspiegel und einem Stromsteuertransistor, bei dem der Strommeßwiderstand und die Kollektor-Emitter-Strecke des Stromsteuertransistors in Reihe liegen, der dadurch gekennzeichnet ist, daß der Stromspiegel zwei sekundäre Stromspiegeltransistoren aufweist, daß ein zweiter Stromspiegel mit einem primären Stromspiegeltransistor und einem sekundären Stromspiegeltransistor vorgesehen ist, daß die Emitter-Kollektor-Strecke des ersten sekundären Stromspiegeltransistors des ersten Stromspiegels mit der Kollektor-Emitter-Strecke des primären Stromspiegeltransistors des zweiten Stromspiegels und die Emitter-Kollektor-Strecke des zweiten sekundären Stromspiegeltransistors des ersten Stromspiegels mit der Kollektor-Emitter-Strecke des sekundären Stromspiegeltransistors des zweiten Stromspiegels in Reihe liegen, daß der Emitter des primären Stromspiegeltransistors des zweiten Stromspiegels an die Verbindung des Emitters des Stromsteuertransistors mit dem Strommeßwiderstand und der Emitter des sekundären Stromspiegeltransistors des zweiten Stromspiegels an das andere Ende des Strommeßwiderstandes angeschlossen sind und daß die Basis des Stromsteuertransistors an die Verbindung des zweiten sekundären Stromspiegeltransistors des ersten Stromspiegels mit dem sekundären Stromspiegeltransistor des zweiten Stromspiegels angeschlossen ist.

Im folgenden wird nun die Erfindung anhand einer lediglich ein Ausführungsbeispiel darstellenden Zeichnung ausführlicher erläutert; es zeigt

Fig. 1    ein Blockschaltbild eines elektronischen, berührungslos arbeitenden Schaltgerätes und

Fig. 2    ein vereinfachtes Schaltbild eines Teils des erfindungsgemäßen elektronischen Schaltgerätes, nämlich den Konstantstromgenerator.

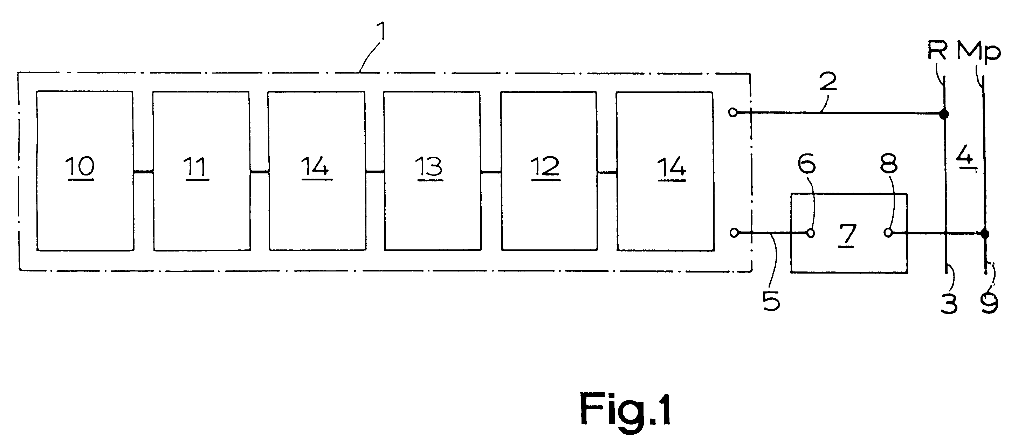

Das in Fig. 1 mit Hilfe eines Blockschaltbildes dargestellte elektronische Schaltgerät 1 arbeitet berührungslos, d. h. es spricht z. B. auf ein sich annäherndes, nicht dargestelltes Metallteil an, und ist im dargestellten Ausführungsbeispiel über einen Außenleiter 2 an einen Pol 3 einer Betriebsspannungsquelle 4 und nur über einen weiteren Außenleiter 5 an einen Anschluß 6 eines Verbrauchers 7 angeschlossen, - während der andere Anschluß 8 des Verbrauchers 7 an den anderen Pol 9 der Betriebsspannungsquelle 4 angeschlossen ist. Mit anderen Worten ist das dargestellte Schaltgerät 1 in bekannter Weise über insgesamt nur zwei Außenleiter 2, 5 einerseits an die Betriebsspannungsquelle 4 und andererseits an den Verbraucher 7 angeschlossen.

Wie Fig. 1 zeigt, besteht das dargestellte Schaltgerät 1 in seinem grundsätzlichen Aufbau aus einem von außen beeinflußbaren Anwesenheitsindikator 10, z. B. einem Oszillator, einem dem Anwesenheitsindikator 10 nachgeordneten Schaltverstärker 11, einem von dem Anwesenheitsindikator 10 über den Schaltverstärker 11 steuerbaren elektronischen Schalter 12, z. B. einem Thyristor, einer Speiseschaltung 13 zur Darstellung der Speisespannung für den Anwesenheitsindikator 10 und den Schaltverstärker 11 und einem Konstantstromgenerator 14. Eingangsseitig ist noch eine Gleichrichterbrücke 15 vorgesehen, weil es sich bei der Betriebsspannungsquelle 4 um eine Wechselspannungsquelle handelt.

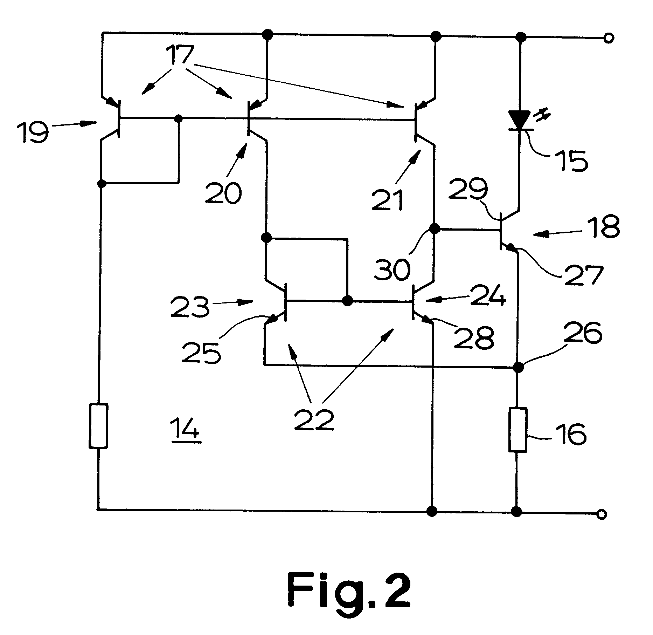

Wie die Fig. 2 zeigt, ist der Konstantstromgenerator 14 für die Stromversorgung einer Leuchtdiode 15 vorgesehen, weist der Konstantstromgenerator 14 einen Strommeßwiderstand 16, einen Stromspiegel 17 und einen Stromsteuertransistor 18 auf und liegen der Strommeßwiderstand 16 und die Kollektor-Emitter-Strecke des Stromsteuertransistors 18 in Reihe.

Für das erfindungsgemäße, in Fig. 1 dargestellte elektronische Schaltgerät 1 gilt nun, wie Fig. 2 zeigt, daß der Stromspiegel 17 - neben einem primären Stromspiegeltransistor 19 - zwei sekundäre Stromspiegeltransistoren 20, 21 aufweist, daß ein zweiter Stromspiegel 22 mit einem primären Stromspiegeltransistor 23 und einem sekundären Stromspiegeltransistor 24 vorgesehen ist, daß die Emitter-Kollektor-Strecke des ersten sekundären Stromspiegeltransistors 20 des ersten Stromspiegels 17 mit der Kollektor-Emitter-Strecke des primären Stromspiegeltransistors 23 des zweiten Stromspiegels 22 und die Emitter-Kollektor-Strecke des zweiten sekundären Stromspiegeltransistors 21 des ersten Stromspiegels 17 mit der Kollektor-Emitter-Strecke des sekundären Stromspiegeltransistors 24 des zweiten Stromspiegels 22 in Reihe liegen, daß der Emitter 25 des primären Stromspiegeltransistors 23 des zweiten Stromspiegels 22 an die Verbindung 26 des Emitters 27 des Stromsteuertransistors 18 mit dem Strommeßwiderstand 16 und der Emitter 28 des sekundären Stromspiegeltransistors 24 des zweiten Stromspiegels 22 an das andere Ende des Strommeßwiderstandes 16 angeschlossen sind und daß die Basis 29 des Stromsteuertransistors 18 an die Verbindung 30 des zweiten sekundären Stromspiegeltransistors 21 des ersten Stromspiegels 17 mit dem sekundären Stromspiegeltransistor 24 des zweiten Stromspiegels 22 angeschlossen ist.

## Patentansprüche

1.    Elektronisches, vorzugsweise berührungslos arbeitendes Schaltgerät (1), mit einem von außen beeinflußbaren Anwesenheitsindikator (10), z. B. einem Oszillator, mit einem dem Anwesenheitsindikator nachgeordneten Schaltverstärker (11), mit einem von dem Anwesenheitsindikator über den Schaltverstärker steuerbaren elektronischen Schalter (12), z. B. einem Transistor, einem Thyristor oder einem Triac, mit einer Speiseschaltung (13) zur Darstellung der Speisespannung für den Anwesenheitsindikator und für den Schaltverstärker und mit einem Konstantstromgenerator (14), z. B. für die Stromversorgung einer Leuchtdiode, wobei der Konstantstromgenerator einen Strommeßwiderstand (16), einen Stromspiegel (17) und einen Stromsteuertransistor (18) aufweist und der Strommeßwiderstand und die Kollektor-Emitter-Strecke des Stromsteuertransistors in Reihe liegen, **dadurch gekennzeichnet**, daß der Stromspiegel (17) zwei sekundäre Stromspiegeltransistoren (20, 21) aufweist, daß ein zweiter Stromspiegel (22) mit einem primären Stromspiegeltransistor (23) und einem sekundären Stromspiegeltransistor (24) vorgesehen ist, daß die Emitter-Kollektor-Strecke des ersten sekundären Stromspiegeltransistors (20) des ersten Stromspiegels (17) mit der Kollektor-Emitter-Strecke des primären Stromspiegeltransistors (23) des zweiten Stromspiegels (22) und die Emitter-Kollektor-Strecke des zweiten sekundären Stromspiegeltransistors (21) des ersten Stromspiegels (17) mit der Kollektor-Emitter-Strecke des sekundären Stromspiegeltransistors (24) des zweiten Stromspiegels (22) in Reihe liegen, daß der Emitter (25) des primären Stromspiegeltransistors (23) des zweiten Stromspiegels (22) an die Verbindung (26) des Emitters (27) des Stromsteuertransistors (18) mit dem Strommeßwiderstand (16) und der Emitter (28) des sekundären Stromspiegeltransistors (24) des zweiten Stromspiegels (22) an das andere Ende des Strommeßwiderstandes (16) angeschlossen sind und daß die Basis (29) des Stromsteuertransistors (18) an die Verbindung (30) des zweiten sekundären Stromspiegeltransistors (21) des ersten Stromspiegels (17) mit dem sekundären Stromspiegeltransistor (24) des zweiten Stromspiegels (22) angeschlossen ist.

2. Elektronisches Schaltgerät nach Anspruch 1, dadurch gekennzeichnet, daß der erste Stromspiegel (17) Stromspiegelfaktoren hat, die ungleich 1 sind.

3. Elektronisches Schaltgerät nach Anspruch 2, dadurch gekennzeichnet, daß die Stromspiegelfaktoren des ersten Stromspiegels (17) ungleich sind.

4. Elektronisches Schaltgerät nach einem der Ansprüche 1 bis 3, dadurch gekennzeichnet, daß der zweite Stromspiegel (22) einen Stromspiegelfaktor hat, der ungleich 1 ist.

5. Konstantstromgenerator (14) mit einem Strommeßwiderstand (16), einem Stromspiegel (17) und einem Stromsteuertransistor (18), bei dem der Strommeßwiderstand und die Kollektor-Emitter-Strecke des Stromsteuertransistors in Reihe liegen, wobei der Stromspiegel (17) zwei sekundäre Stromspiegeltransistoren (20, 21) aufweist, ein zweiter Stromspiegel (22) mit einem primären Stromspiegeltransistor (23) und einem sekundären Stromspiegeltransistor (24) vorgesehen ist, die Emitter-Kollektor-Strecke des ersten sekundären Stromspiegeltransistors (20) des ersten Stromspiegels (17) mit der Kollektor-Emitter-Strecke des primären Strom-spiegeltransistors (23) des zweiten Stromspie-gels (22) und die Emitter-Kollektor-Strecke des zweiten sekundären Stromspiegeltransistors (21) des ersten Stromspiegels (17) mit der Kollektor-Emitter-Strecke des sekundären Stromspiegeltransistors (24) des zweiten Stromspiegels (22) in Reihe liegen, der Emitter (25) des primären Stromspiegeltransistors (23) des zweiten Stromspiegels (22) an die Verbindung (26) des Emitters (27) des Stromsteuertransistors (18) mit dem Strommeßwiderstand (16) und der Emitter (28) des sekundären Stromspiegeltransistors (24) des zweiten Stromspiegels (22) an das andere Ende des Strommeßwiderstandes (16) angeschlossen sind und wobei die Basis (29) des Stromsteuertransistors (18) an die Verbindung (30) des zweiten sekundären Stromspiegeltransistors (21) des ersten Stromspiegels (17) mit dem sekundären Stromspiegeltransistor (24) des zweiten Stromspiegels (22) angeschlossen ist.

6. Konstantstromgenerator nach Anspruch 5, dadurch gekennzeichnet, daß der erste Stromspiegel (17) Stromspiegelfaktoren hat, die ungleich 1 sind.

7. Konstantstromgenerator nach Anspruch 6, da-durch gekennzeichnet, daß die Stromspiegelf-aktoren des ersten Stromspiegels (17) ungleich sind.

8. Konstantstromgenerator nach einem der Ansprüche 5 bis 7, dadurch gekennzeichnet, daß der zweite Stromspiegel (22) einen Stromspiegelfaktor hat, der ungleich 1 ist.

## Claims

1. An electronic switching device (1), preferably operating without contact, with an externally influenceable presence indicator (10), e.g. an oscillator, with a switching amplifier (11) connected downstream of the presence indicator, with an electronic switch (12), e.g. a transistor, a thyristor or a triac, which is controllable by the presence indicator via the switching amplifier, with a supply circuit (13) for producing the supply voltage for the presence indicator and for the switching amplifier, and with a constant current generator (14), e.g. for the supply of current to a light-emitting diode, wherein the constant current generator comprises a current measuring resistor (16), a current reflector (17) and a current control transistor (18) and the current measuring resistor and the collector-emitter segment of the current control transistor are connected in series, characterised in that the current reflector (17) comprises two secondary current reflector transistors (20, 21), that a second current reflector (22) is provided, having a primary current reflector transistor (23) and a secondary current reflector transistor (24), that the emitter-collector segment of the first secondary current reflector transistor (20) of the first current reflector (17) is in series with the collector-emitter segment of the primary current reflector transistor (23) of the second current reflector (22), and the emitter-collector segment of the second secondary current reflector transistor (21) of the first current reflector (17) is in series with the collector-emitter segment of the secondary current reflector transistor (24) of the second current reflector (22), that the emitter (25) of the primary current reflector transistor (23) of the second current reflector (22) is connected to the connection (26) between the emitter (27) of the current control transistor (18) and the current measuring resistor (16), and the emitter (28) of the secondary current reflector transistor (24) of the second current reflector (22) is connected to the other end of the current measuring resistor (16), and that the base (29) of the current control transistor (18) is connected to the connection (30) between the second secondary current reflector transistor (21) of the first current reflector (17) and the secondary current reflector transistor (24) of the second current reflector (22).

2. An electronic switching device according to claim 1, characterised in that the first current reflector (17) has current reflection factors which are unequal to 1.

3. An electronic switching device according to claim 2, characterised in that the current reflection factors of the first current reflector (17) are unequal.

4. An electronic switching device according to any one of claims 1 to 3, characterised in that the second current reflector (22) has a current reflection factor which is unequal to 1.

5. A constant current generator (14) with a current measuring resistor (16), a current reflector (17) and a current control transistor (18), wherein the current measuring resistor and the collector-emitter section of the current control transistor are connected in series, wherein the current reflector (17) comprises two secondary current reflector transistors (20, 21), a second current reflector (22) is provided, having a primary current reflector transistor (23) and a secondary current reflector transistor (24), the emitter-collector segment of the first secondary current reflector transistor (20) of the first current reflector (17) is in series with the collector-emitter segment of the primary current reflector transistor (23) of the second current reflector (22), and the emitter-collector segment of the second secondary current reflector transistor (21) of the first current reflector (17) is in series with the collector-emitter segment of the secondary current reflector transistor (24) of the second current reflector (22), the emitter (25) of the primary current reflector transistor (23) of the second current reflector (22) is connected to the connection (26) between the emitter (27) of the current control transistor (18) and the current measuring resistor (16) and the emitter (28) of the secondary current reflector transistor (24) of the second current reflector (22) is connected to the other end of the current measuring resistor (16), and wherein the base (29) of the current control transistor (18) is connected to the connection (30) between the second secondary current reflector transistor (21) of the first current reflector (17) and the secondary current reflector transistor (24) of the second current reflector (22).

6. A constant current generator according to claim 5, characterised in that the first current reflector (17) has current reflection factors which are unequal to 1.

7. A constant current generator according to claim 6, characterised in that the current reflection factors of the first current reflector (17) are unequal.

8. A constant current generator according to any one of claims 5 to 7, characterised in that the second current reflector (22) has a current reflection factor which is unequal to 1.

**Revendications**

1. Appareil de coupure électronique (1) travaillant de préférence sans contact, comportant un indicateur de présence (10), qui peut être influencé de l'extérieur, par exemple un oscillateur, et comportant un amplificateur de coupure (11) branché en aval de l'indicateur de présence, un interrupteur électronique (12), par exemple un. transistor, un thyristor ou un triac, commandable par l'indicateur de présence par l'intermédiaire de l'amplificateur de coupure, un circuit d'alimentation (13) pour délivrer la tension d'alimentation pour l'indicateur de présence et pour l'amplificateur de coupure, et un générateur de courant constant (14), par exemple pour l'alimentation en courant d'une diode à luminescence, le générateur de courant constant comportant une résistance de mesure de courant (16), un miroir de courant (17) et un transistor (18) de commande de courant, tandis que la résistance de mesure du courant et la section collecteur-émetteur du transistor de commande du courant sont branchées en série, caractérisé en ce que le miroir de courant (17) possède deux transistors secondaires (20,21), qu'il est prévu un second miroir de courant (22) comportant un transistor primaire (23) et un transistor secondaire (24), que la section émetteur-collecteur du premier transistor secondaire (20) du premier miroir de courant (17) est branchée en série avec la section collecteur-émetteur du transistor primaire (23) du second miroir de courant (22) et que la section émetteur-collecteur du second transistor secondaire (21) du premier miroir de courant (17) est branchée en série avec la section collecteur-émetteur du transistor secondaire (24) du second miroir de courant (22), que l'émetteur (25) du transistor primaire (23) du second miroir de courant (22) est raccordé au point de jonction (26) entre l'émetteur (27) du transistor de commande de courant (18) et de résistance de mesure de courant (16) et que l'émetteur (28) du transistor secondaire (24) du second miroir de courant (22) est raccordé à l'autre extrémité de la résistance de mesure du courant (16), et que la base (29) de transistor de commande de courant (18) est raccordée au point de jonction (30) entre le second transistor secondaire (21) du premier miroir de courant (17) et le transistor secondaire (24) du second miroir de courant (22).

2. Appareil de coupure électronique selon la revendication 1, caractérisé en ce que le premier miroir de courant (17) possède des facteurs qui sont différents de 1.

3. Appareil de coupure électronique selon la revendication 2, caractérisé en ce que les facteurs du premier miroir de courant (17) sont différents.

4. Appareil de coupure électronique selon l'une des revendications 1 à 3, caractérisé en ce que le second miroir de courant (22) possède un facteur qui est différent de 1.

5. Générateur de courant constant (14) comportant une résistance de mesure de courant (16), un miroir de courant (17) et un transistor de commande de courant (18), et dans lequel la résistance de mesure de courant et la section collecteur-émetteur du transistor de commande de courant sont branchées en série, le miroir de courant (17) possède deux transistors secondaires (20,21), il est prévu un second miroir de courant (22) comportant un transistor primaire (23) et un transistor secondaire (24), la section émetteur-collecteur du premier transistor secondaire (20) du premier miroir de courant (17) est branchée en série avec la section collecteur-émetteur du transistor primaire (23) du second miroir de courant (22) et la section émetteur-collecteur du second transistor secondaire (21) du premier miroir de courant (17) est branchée en série avec la section collecteur-émetteur du transistor secondaire (24) du second miroir de courant (22), l'émetteur (25) du transistor primaire (23) du second miroir de courant (22) est raccordé au point de jonction (26) entre l'émetteur (27) du transistor de commande de courant (18) et de la résistance de mesure de courant (16) et l'émetteur (28) du transistor secondaire (24) du second miroir de courant (22) est raccordé à l'autre extrémité de la résistance de mesure du courant (16), et la base (29) du transistor de commande de courant (18) est raccordée au point de jonction (30) entre le second transistor secondaire (21) du premier miroir de courant (17) et le transistor secondaire (24) du second miroir de courant (22).

6. Générateur de courant constant selon la revendication 5, caractérisé en ce que le premier miroir de courant (17) possède des facteurs qui sont différents de 1.

7. Générateur de courant constant selon la revendication 6, caractérisé en ce que les facteurs du premier miroir de courant (17) sont différents.

8. Générateur de courant constant selon l'une des revendications 5 à 7, caractérisé en ce que le second miroir de courant (22) possède un facteur qui est différent de 1.

Fig.1

EP 0 298 329 B1

**Fig.2**

EP 0 298 329 B1